(19) Europäisches Patentamt

European Patent Office

Office européen des brevets

(11) EP 1 669 978 A1

(12) EUROPEAN PATENT APPLICATION

(43) Date of publication:
14.06.2006 Bulletin 2006/24

(51) Int Cl.:
G10L 11/02 (2006.01)          H03M 1/18 (2006.01)
H03G 3/20 (2006.01)          G10L 15/02 (2006.01)

(21) Application number: 05026106.4

(22) Date of filing: 30.11.2005

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 07.12.2004 KR 2004102613

(71) Applicant: Samsung Electronics Co., Ltd.
Suwon-si, Gyeonggi-Do (KR)

(72) Inventors:
• Jeong, Myeong-Gi
Suwon-si
Gyeonggi-do (KR)
• Shim, Hyun-Sik
Sanghyun-dong 855
Yongin-si
Gyeonggi-do (KR)
• Lee, Jong-Chang
Suwon-si
Gyeonggi-do (KR)
• Kim, Kwang-Choon
Yeongtong-gu
Suwon-si
Gyeonggi-do (KR)

(74) Representative: Lang, Johannes
Bardehle Pagenberg Dost Altenburg Geissler,
Postfach 86 06 20
81633 München (DE)

(54) **Speech detection system and method for automatically controlling the input level of speech signals**

(57)    A speech detection system comprises: a speech pickup element for picking up speech from an external speaker; a speech level controller for receiving the picked up speech at a speech input level provided by a speech detector, and outputting the received speech to the speech detector, for detecting a speech signal period needed for speech recognition from the speech output from the speech receiver; a speech saturation detector for determining, based on the threshold value, whether the speech signal in the detected speech signal period is saturated; and an input level determiner for determining a new speech input level, and outputting information on the new speech input level to the speech receiver when the speech signal in the speech signal period is saturated, whereby the speech receiver receives the speech in a unsaturated state. A speech detection method comprises steps corresponding to the functions of the system as specified above.

FIG. 3

**Description**

BACKGROUND OF THE INVENTION

Technical Field

The present invention relates to a speech recognition system and, more particularly, to a speech recognition system and a speech recognition method capable of controlling an input level of speech depending on whether a speech signal period of the input speech is detected, and whether the speech signal in the speech signal period is saturated.

Related Art

In general, a speech recognition system or method produces a feature vector of input speech through various analytical methods using a frequency analysis scheme, and utilizes the produced feature vector to recognize the speech. The speech recognition system or method uses one of various speech recognition schemes which use the energy of an input speech signal.

In such a speech recognition system or method using the energy of an input speech signal, the energy of the input speech signal is normalized to minimize deviation therein for the purpose of recognizing the speech. In this regard, energy levels (or signal levels) of the input speech signal are not individually checked at specific instances of time.

In existing speech recognition systems or methods, there is concern that the speech recognition rate may be degraded when speech detection fails due to the input level of the speech signal being too low, or when the speech input level deviates from speech input resolution for a certain period of time due to the speech input level being too high. However, speech recognition systems or methods do not compensate for degraded speech recognition in such situations.

The speech recognition system or method does not control the speech input level to be within an available range depending on the level of the input speech. Accordingly, the speech recognition system or method undergoes speech detection failure due to a low speech input level, or undergoes input signal saturation in a speech period due to a high speech input level, which degrades the speech recognition rate.

Because the user of the speech recognition system or method continuously uses the system or method several times, starting from a certain point in time, instead of using it periodically at certain intervals, there is a high likelihood that input level correction resulting from initial recognition will affect subsequent recognition. Furthermore, when a plurality of users use a single speech recognition system or method, there may be a number of cases in which speech volume and input characteristics (e.g., the distance between a microphone and a speaker) differ. In such cases, the speech input level of the speech recognition system or method should be controlled in real time as the user changes. However, in the speech recognition system or method, each individual user has to manually control the speech input level.

SUMMARY OF THE INVENTION

It is an object of the present invention to provide a speech recognition system and a speech recognition method using the same, the system and method being capable of automatically and actively controlling speech input level by analyzing speech uttered by a user, such that the speech is recognized as speech in a speech recognition period.

It is another object of the present invention to provide a speech recognition system and method which are capable of enhancing detection rate and recognition rate of input speech by adapting to varying speech volume and changing utterance patterns.

According to an embodiment of the present invention, there is provided a speech recognition system comprising: a speech receiver for picking up and receiving speech at a set speech input level, and for outputting the received speech; and a speech recognizer for determining and outputting the speech input level to the speech receiver, the determination being based on whether a speech signal in a speech signal period of the received speech is saturated based on a set threshold value.

Preferably, the speech receiver includes: a speech pickup for picking up the speech from an external speaker; and a speech level controller for receiving the picked-up speech at the speech input level provided by the speech recognizer, and for outputting the received speech to the speech recognizer.

Preferably, the speech recognizer includes: a speech detector for detecting the speech signal period from the speech received by the speech receiver; a speech saturation detector for determining, based on the threshold value, whether the speech signal in the detected speech signal period is saturated; and an input level determiner for determining a new speech input level, and for outputting information on the new speech input level to the speech receiver when the speech signal in the speech signal period is saturated, such that the speech receiver receives the speech in an unsaturated state.

In one embodiment, the system further includes a speech corrector for performing speech recognition processing on the speech signal in the speech signal period detected by the speech detector when the speech signal in the detected speech signal period is determined to be not saturated.

The speech detector detects the speech signal period by using an energy value and a zero crossing rate of the speech signal received by the speech receiver.

The speech saturation detector calculates an average energy value of the speech signal period and if, the calculated average energy value is more than a specific threshold value, determines that the speech signal in the speech signal period is saturated.

The speech saturation detector divides the speech signal period into a few or tens of short periods and, if the value of the speech signal in each short period is greater than the speech input resolution, determines that the speech signal in the speech signal period is saturated.

The input level determiner determines a new speech input level when the speech detector fails to detect the speech signal period.

The input level determiner determines the new speech input level $Mic_{NEW}$ to be an intermediate value between a set current speech input level $Mic_{OLD}$ and a maximum allowable speech input level value $Mic_{MAX}$ when the speech detector fails to detect the speech signal period.

The input level determiner determines the new speech input level $Mic_{NEW}$ to be an intermediate value between a set current speech input level $Mic_{OLD}$ and a minimum allowable speech input level value $Mic_{MIN}$ when the speech saturation detector determines that the speech signal in the speech signal period is saturated.

Meanwhile, according to another embodiment of the present invention, there is provided a speech recognition method using a speech recognition system, the method comprising the steps of: picking up, receiving and outputting speech at a set speech input level; detecting, from the output speech, a speech signal period which is needed for speech recognition; determining, based on a threshold value, whether a speech signal in the detected speech signal period is saturated; when the speech signal in the speech signal period is saturated, determining a new speech input level for receiving the speech in an unsaturated state; and picking up and receiving the speech at the new speech input level.

Preferably, the step of detecting the speech signal period includes using an energy value and a zero crossing rate of the speech signal.

The step of determining whether the speech signal is saturated includes calculating an average energy value of the speech signal period and, if the calculated average energy value is more than a specific threshold value, determining that the speech signal in the speech signal period is saturated.

The step of determining whether the speech signal is saturated includes dividing the speech signal period into a few or tens of short periods and, if a value of a speech signal in each short period is greater than speech input resolution, determining that the speech signal in the speech signal period is saturated.

The step of determining the new speech input level is performed when detection of the speech signal period fails.

The step of determining the new speech input level includes determining the new speech input level $Mic_{NEW}$ to be an intermediate value between a set current speech input level $Mic_{OLD}$ and a maximum allowable speech input level value $Mic_{MAX}$ when the step of detecting the speech signal period fails to detect the speech signal period.

The step of determining the new speech input level includes determining the new speech input level $Mic_{NEW}$ to be an intermediate value between a set current speech input level $Mic_{OLD}$ and a minimum allowable speech input level value $Mic_{MIN}$ when the step of determining whether the speech signal is saturated determines that the speech signal in the speech signal period is saturated.

According to the present invention, it is possible to reduce the rate of failure to detect speech from the input speech signal and degradation of the speech recognition rate due to speech signal saturation by controlling the speech input level, depending on whether the speech signal period is detected from the input speech signal and whether the speech signal in the detected speech signal period is saturated. Furthermore, it is possible to reduce the speech detection failure rate and degradation of the speech recognition rate by adapting to varying speech volume and utterance patterns (the distance between the microphone and the speaker) from speaker to speaker by actively controlling the speech input level, instead of the user directly controlling the speech input level when the speech signal period detection fails or when the detected speech signal is saturated.

BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:

FIG. 1 illustrates an example of the result when a speech recognition system fails to detect speech;

FIG. 2 illustrates another example of the result when a speech recognition system fails to detect speech;

FIG. 3 is a block diagram of a speech recognition system which automatically controls a speech input level according to a preferred embodiment of the present invention;

FIGs. 4A and 4B illustrate the principle of detecting a speech signal period by using the energy and the zero crossing rate of a speech signal in a speech detector of FIG. 3; and

FIG. 5 is a flowchart showing a speech recognition method using a speech recognition system according to a preferred embodiment of the present invention.

DETAILED DESCRIPTION OF THE INVENTION

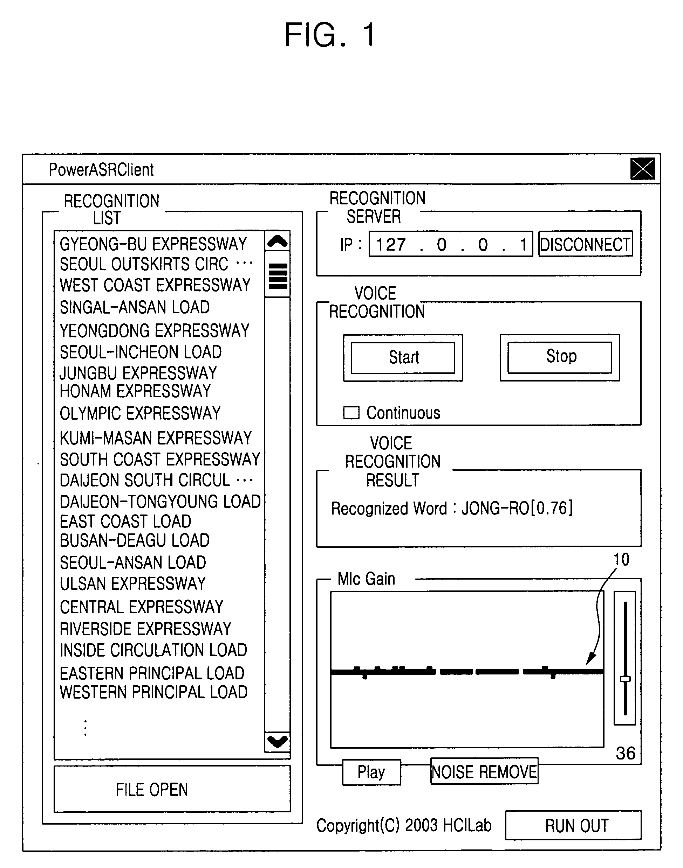

FIG. 1 illustrates an example of the result when a speech recognition system fails to detect speech.

Referring to FIG. I, data 10 results when speech detection fails because input speech has a signal level below a range set as a speech recognition period.

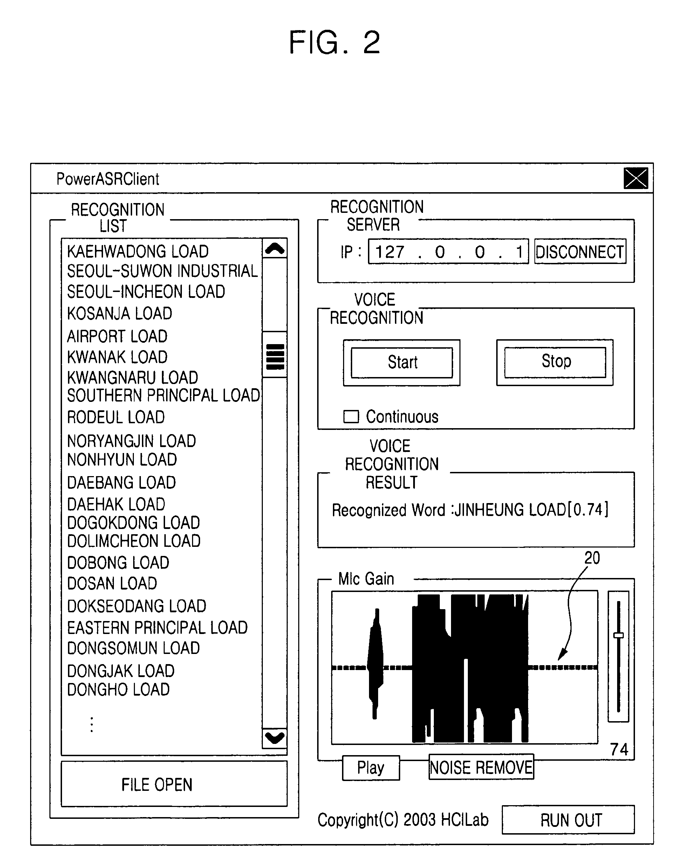

FIG. 2 illustrates another example of the result when a speech recognition system fails to detect speech.

Referring to FIG. 2, data 20 results when speech recognition fails because the input speech has a high (saturation) signal level above a range set as the speech recognition period.

As shown in FIGS. 1 and 2, upon failure of speech recognition, the speech recognition system allows the user to directly control the speech input level based on the reason why speech recognition fails. For example, the user controls the distance between a microphone receiving speech input and the speaker, or the user controls the microphone gain of an input device so as to thereby control the input level.

The present invention will now be described more fully with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the concept of the invention to those skilled in the art.

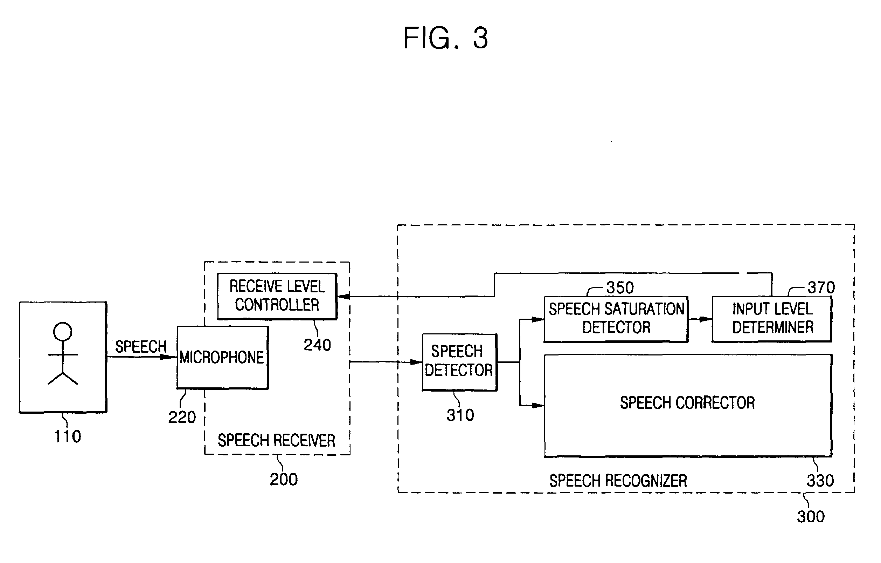

FIG. 3 is a block diagram of a speech recognition system which automatically controls a speech input level according to a preferred embodiment of the present invention.

Referring to FIG. 3, only primary elements of the speech recognition system are shown and elements which are not related to the present invention are omitted. This speech recognition system may be implemented as a single system, or may be implemented with a client/server-type network structure.

As shown in FIG. 3, the speech recognition system has a speech receiver 200 and a speech recognizer 300.

The speech receiver 200 picks up speech uttered by a speaker 110, and outputs the picked-up speech to the speech recognizer 300.

The speech receiver 200 has a microphone 220 and a receive level controller 240.

The microphone 220 picks up the speech uttered by the speaker 110, and the receive level controller 240 receives the speech picked up by the microphone 220 at a level determined by input level information.

The speech recognizer 300 determines whether a speech period of the speech signal input from the speech receiver 200 is saturated, determines the speech input level for the receive level controller 240 based on that result, performs correction on the speech in the speech period, recognizes the corrected speech as speech to be actually used, and outputs the corrected speech to the relevant block.

The speech recognizer 300 has a speech detector or an end point detector (EPD) 310, a speech corrector 330, a speech saturation detector 350, and an input level determiner 370. The speech saturation detector 350 and the input level determiner 370 are configured so as to be included in the speech recognizer 300 so that a single system directly controls the speech receiver 200. The speech saturation detector 350 and the input level determiner 370 may be implemented in a client or a server connected to a network.

The speech detector 310 detects a speech signal period, which is needed for speech recognition, from the speech signal input from the speech receiver 200. The speech detector 310 uses the energy and the zero crossing rate of the speech signal when detecting the actual speech signal period needed for the speech recognition from the input speech signal.

The speech corrector 330 reduces noise contained in the speech in the speech signal period detected by the speech detector 310, and then recognizes and outputs the resultant corrected speech as speech to be actually used.

The speech saturation detector 350 determines whether the speech signal within the speech signal period detected by the speech detector 310 is saturated. A method for determining whether the speech signal is saturated, based on criteria for determining the input level control in the speech saturation detector 350, will be discussed below.

The speech saturation detector 350 calculates the average energy of the input speech signal and, if the calculated average energy is more than a specific threshold value, determines that the speech signal is saturated. Furthermore, the speech saturation detector 350 divides the speech period into a few or tens of short periods and, if the value of a speech signal in each period is greater than speech input resolution, may determine that the speech signal is saturated.

The input level determiner 370 determines a control extent of the input level in the receive level controller 240 by referring to the speech signal period detected by the speech detector 310 and the speech saturation status detected by the speech saturation detector 350.

The input level determiner 370 determines an input level of the speech which will be controlled by the receive level controller 240 of the speech receiver 200 when the speech detector 310 fails to detect an end point of the speech in detecting the speech signal period or when the speech saturation detector 350 determines that the speech signal is saturated. In this regard, the input level determiner 370 sends the determined input level information to the receive level controller 240 of the speech input unit 200.

Accordingly, the receive level controller 240 receives the speech of the speaker 110 picked up by the microphone 220 at a level corresponding to the input level information which is provided by the input level determiner 370.

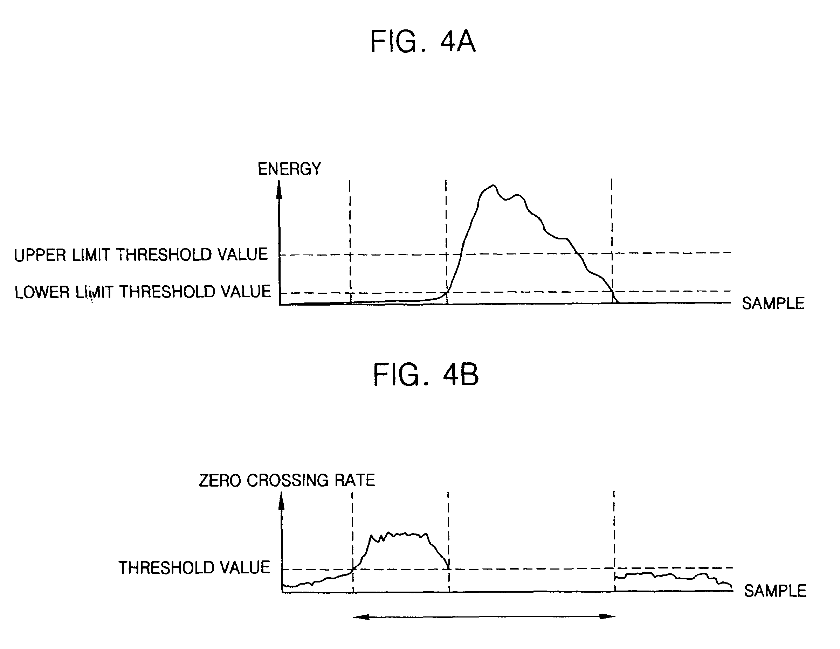

FIGs. 4A and 4B illustrate the principle of detecting a speech signal period by using the energy and the zero crossing rate of a speech signal in the speech detector of FIG. 3.

Upon receipt of the input speech signal, the speech detector 310 measures the energy and the zero crossing rate of the input speech signal.

FIG. 4A is a graph representing an energy value of the speech signal measured by the speech detector 310 for a plurality of samples.

The speech detector 310 determines that the speech has begun when the energy value is more than an upper limit threshold value Thr.U, and determines that the speech period has begun from a time point preceding when the speech actually begins by a certain sample period. The speech detector 310 also determines that the speech period has ended when a sample period in which the energy value drops below a lower limit threshold value Thr.L is sustained for a predetermined duration.

FIG. 4B is a graph representing a zero crossing rate value calculated by the speech detector 310 for each sample.

The speech detector 310 detects the speech period based on both the energy value of the speech signal, as shown in FIG. 4A, and the zero crossing rate, as shown in FIG. 4B. The zero crossing rate indicates the frequency with which the speech signal level intersects zero. The speech detector 310 determines that the speech signal level intersects zero based on whether multiplication of a current speech signal sample value and a preceding speech signal sample value yields a positive or negative result. This criterion is available because the speech signal necessarily contains a periodic signal period in a corresponding period, and because the zero crossing rate in the periodic signal period is significantly less than in a period having no speech.

As shown in FIG. 4B, it can be seen that the zero crossing rate of the period having no speech appears to be greater than a threshold value Thr.ZCR. In contrast, it can be seen that there is no zero crossing rate appearing in the speech period.

The speech detector 310 sends the detected speech signal to the speech saturation detector 350 when speech detection is successful.

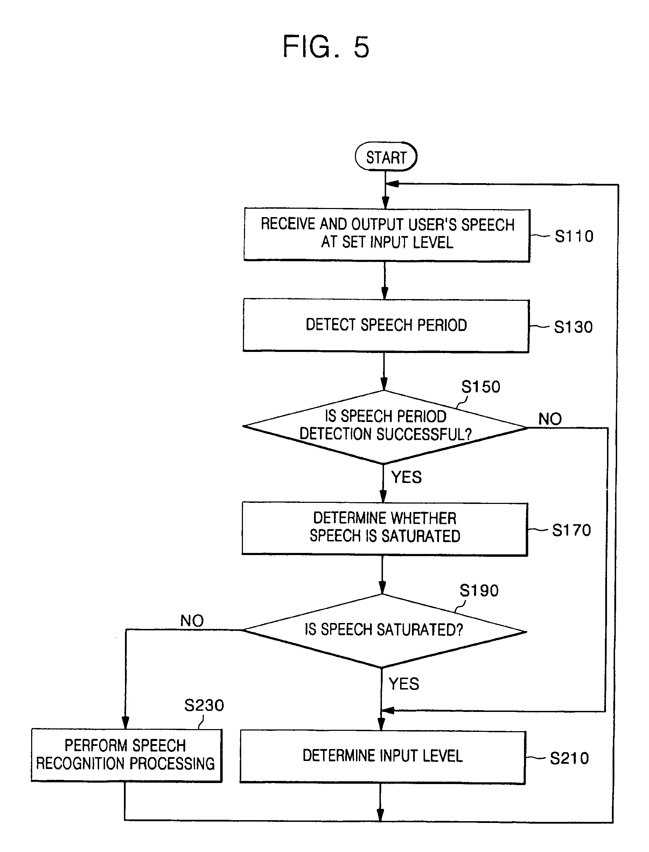

FIG. 5 is a flowchart showing a speech recognition method using a speech recognition system according to a preferred embodiment of the present invention.

The receive level controller 240 in the speech receiver 200 receives a user's speech at a set input level and outputs the received speech to the speech recognizer 300 (S 110). The speech detector 310 in the speech recognizer 300 detects the actual speech signal period from the input speech (S130). In this embodiment, the speech detector 310 uses the energy and the zero crossing rate of the speech signal to detect the speech signal period.

When the speech period detection is successful (S150), the speech saturation detector 350 analyzes the detected speech signal to determine whether the speech is saturated (S170). Here, the speech saturation detector 350 may use the speech energy or the speech data value to determine whether the speech is saturated. Specifically, the speech saturation detector 350 divides the speech period into short periods of approximately 10 to 40 msec. The speech period is divided into the short periods because the time-varying speech signal exhibits a stationary feature in the short periods. In the case where the energy of the speech signal is used to detect speech saturation, the speech saturation detector 350 calculates the energy of the speech data in the short speech periods using Equation 1:

$$\underline{\text{Equation 1}}$$

$$E_j \, , \frac{1}{N} \sum_{n=1}^{N-1} x_j^2 \left[ n \right] ,$$

where $E_j$ is average energy in a j-th speech period, $N$ is the number of data (number of samples) in a short speech period, and $x_j^2 \left[ n \right]$ is speech data in the j-th speech period.

The speech saturation detector 350 compares the energy value of the calculated speech period to an energy threshold value at which the speech signal may be determined to be saturated. If the energy value is greater than the threshold value, the speech saturation detector 350 determines that the input speech signal is saturated (S190).

In this case, the energy threshold value beyond which the speech signal is saturated may be detennined by the speech input resolution. For example, if the speech signal has 16-bit resolution, the speech data has a range of $2^{16}$, and thus this value may be used to calculate the threshold value.

In the case where the data value of the speech signal is used to determine whether the speech is saturated, the speech saturation determiner 350 determines that the input speech signal is saturated when several successive speech data values in a divided speech period are equal to a maximum value $M_{MAX}$ permitted by the resolution, as expressed by Equation 2:

Equation 2

$$*x_j \, [n] \, *\exists \; X_{MAX}, \quad n = t, \, t + 1, \, ..., \, t + L,$$

where $M_{MAX}$ is the maximum value set depending on the resolution of the input signal (e.g., 16 bits), t is each position of speech data in a j-th speech period, and L is the set number of successive saturated speech data.

Meanwhile, if the speech detector 310 fails to detect the speech in S 150, or if the speech saturation detector 350 determines in S190 that the speech signal is saturated, the input level determiner 370 determines a new input level which will be applied when the speech receiver 200 receives speech (S210).

Examples of determining the input level include two cases, as expressed in Equation 3 below. First, when the speech detector 310 fails to detect the speech, the input level determiner 370 determines a new speech input level $Mic_{NEW}$ to be an intermediate value between a current speech input level $Mic_{OLD}$ and a maximum speech input level value $Mic_{MAX}$. Second, when the speech saturation detector 350 determines that the speech is saturated, the input level determiner 370 determines the new speech input level $Mic_{NEW}$ to be an intermediate value between the current speech input level $Mic_{OLD}$ and a minimum speech input level value $Mic_{MIN}$.

Equation 3

$$Mic_{NEW} = Mic_{OLD} + ( Mic_{MAX} - Mic_{OLD} ) / 2 : \text{input le-}$$

vel increase, and

$$Mic_{NEW} = Mic_{OLD} - ( Mic_{MAX} - Mic_{OLD} ) / 2 : \text{input le-}$$

vel decrease,

where $Mic_{NEW}$ is the new speech input level, $Mic_{OLD}$ is the existing speech input level, $Mic_{MAX}$ is the input level maximum value, and $Mic_{MIN}$ is the input level minimum value.

After determining the new speech input level $Mic_{NEW}$, the input level determiner 370 provides information on the new speech input level to the receive level controller 240. In response, the receive level controller 240 receives the speech picked up by the microphone 220 at the new speech input level and outputs the received speech to the speech detector 310.

Meanwhile, if it is determined in S 190 that the speech signal is not in a saturation state, the speech corrector 330 reduces noise in the speech signal period detected by the speech detector 310, and performs a normal speech recognition processing operation (S230).

According to the present invention, it is possible to reduce the rate of failure to detect speech from the input speech signal and degradation of a speech recognition rate due to speech signal saturation by controlling the speech input level depending on whether the speech signal period is detected from the input speech signal and whether the speech signal in the detected speech signal period is saturated.

Furthermore, it is possible to reduce the speech detection failure rate and degradation of the speech recognition rate by adapting to varying speech volume and changing utterance patterns (the distance between the microphone and the speaker) from speaker to speaker by actively controlling the speech input level, instead of the user directly controlling the speech input level, when the speech signal period detection fails or when the detected speech signal is saturated.

While the present invention has been particularly shown and described with reference to exemplary embodiments thereof, it will be understood by those of ordinary skill in the art that various changes in form and detail may be made therein without departing from the spirit and scope of the present invention as defined by the following claims and their equivalents.

## Claims

1.  A speech recognition system, comprising:

    a speech receiver for picking up and receiving speech at a set speech input level, and for outputting the received speech; and
    a speech recognizer for determining and outputting the speech input level to the speech receiver, the determination being based on whether a speech signal in a speech signal period of the received speech is saturated based on a threshold value.

2.  The system according to claim 1, wherein the speech receiver comprises:

    a speech pickup element for picking up the speech from an external speaker; and
    a speech level controller for receiving the picked up speech at the speech input level provided by the speech recognizer, and for outputting the received speech to the speech recognizer.

3.  The system according to claim 1, wherein the speech recognizer comprises:

    a speech detector for detecting the speech signal period from a speech output of the speech receiver;
    a speech saturation detector for determining, based on the threshold value, whether the speech signal in the detected speech signal period is saturated; and
    an input level determiner for determining a new speech input level, and
    for outputting information on the new speech input level to the speech receiver when the speech signal in the speech signal period is saturated, whereby the speech receiver receives the speech in an unsaturated state.

4.  The system according to claim 3, said speech recognizer further comprising a speech corrector for performing speech recognition processing on the speech signal in the speech signal period detected by the speech detector when the speech signal in the detected speech signal period is determined to be not saturated.

5.  The system according to claim 3, wherein the speech detector detects the speech signal period by using at least one of an energy value and a zero crossing rate of the speech signal received by the speech receiver.

6.  The system according to claim 3, wherein the speech saturation detector calculates an average energy value of the speech signal period and, when the calculated average energy value is more than a specific threshold value, determines that the speech signal in the speech signal period is saturated.

7.  The system according to claim 3, wherein the speech saturation detector divides the speech signal period into a plurality of periods and, when a value of a speech signal in each period is greater than a speech input resolution, determines that the speech signal in the speech signal period is saturated.

8.  The system according to claim 3, wherein the input level determiner determines a new speech input level when the speech detector fails to detect the speech signal period.

9. The system according to claim 8, wherein the input level determiner determines the new speech input level $Mic_{NEW}$ to be an intermediate value between a set current speech input level $Mic_{OLD}$ and a maximum allowable speech input level value $Mic_{MAX}$ when the speech detector fails to detect the speech signal period.

10. The system according to claim 8, wherein the input level determiner determines the new speech input level $Mic_{NEW}$ to be an intermediate value between a set current speech input level $Mic_{OLD}$ and a minimum allowable speech input level value $Mic_{MIN}$ when the speech saturation detector determines that the speech signal in the speech signal period is saturated.

11. A speech recognition method, comprising the steps of:

    picking-up, receiving and outputting speech at a set speech input level;
    detecting, from the outputted speech, a speech signal period which is needed for speech recognition;
    determining, based on a threshold value, whether a speech signal in the detected speech signal period is saturated;
    when the speech signal in the speech signal period is determined to be saturated, determining a new speech input level for receiving the speech in an unsaturated state; and
    picking up and receiving the speech at the new speech input level.

12. The method according to claim 11, further comprising the step of performing speech recognition processing on the speech signal in the detected speech signal period when the speech signal in the detected speech signal period is determined to be not saturated.

13. The method according to claim 11, wherein the step of detecting the speech signal period comprises using an energy value and a zero crossing rate of the speech signal to detect the speech signal period.

14. The method according to claim 11, wherein the step of determining whether the speech signal is saturated comprises calculating an average energy value of the speech signal period and, when the calculated average energy value is more than a threshold value, determining that the speech signal in the speech signal period is saturated.

15. The method according to claim 11, wherein the step of determining whether the speech signal is saturated comprises dividing the speech signal period into a plurality of periods and, when a value of a speech signal in each period is greater than a speech input resolution, determining that the speech signal in the speech signal period is saturated.

16. The method according to claim 11, wherein the step of determining the new speech input level is performed when detection of the speech signal period fails.

17. The method according to claim 16, wherein the step of determining the new speech input level comprises determining the new speech input level $Mic_{NEW}$ to be an intermediate value between a set current speech input level $Mic_{OLD}$ and a maximum allowable speech input level value $Mic_{MAX}$ when the step of detecting the speech signal period fails to detect the speech signal period.

18. The method according to claim 16, wherein the step of determining the new speech input level comprises determining the new speech input level $Mic_{NEW}$ to be an intermediate value between a set current speech input level $Mic_{OLD}$ and a minimum allowable speech input level value $Mic_{MIN}$ when the step of determining whether the speech signal is saturated determines that the speech signal in the speech signal period is saturated.

# FIG. 1

PowerASRClient  ☒

RECOGNITION LIST

| GYEONG-BU EXPRESSWAY |
| SEOUL OUTSKIRTS CIRC ⋯ |
| WEST COAST EXPRESSWAY |
| SINGAL-ANSAN LOAD |
| YEONGDONG EXPRESSWAY |
| SEOUL-INCHEON LOAD |
| JUNGBU EXPRESSWAY |
| HONAM EXPRESSWAY |
| OLYMPIC EXPRESSWAY |
| KUMI-MASAN EXPRESSWAY |
| SOUTH COAST EXPRESSWAY |
| DAIJEON SOUTH CIRCUL ⋯ |
| DAIJEON-TONGYOUNG LOAD |
| EAST COAST LOAD |
| BUSAN-DEAGU LOAD |
| SEOUL-ANSAN LOAD |
| ULSAN EXPRESSWAY |
| CENTRAL EXPRESSWAY |
| RIVERSIDE EXPRESSWAY |
| INSIDE CIRCULATION LOAD |
| EASTERN PRINCIPAL LOAD |
| WESTERN PRINCIPAL LOAD |
| ⋮ |

FILE OPEN

RECOGNITION SERVER

IP : 127 . 0 . 0 . 1   DISCONNECT

VOICE RECOGNITION

Start     Stop

☐ Continuous

VOICE RECOGNITION RESULT

Recognized Word : JONG-RO[0.76]

Mic Gain

10

36

Play     NOISE REMOVE

Copyright(C) 2003 HCILab     RUN OUT

9

# FIG. 2

**PowerASRClient** ✕

**RECOGNITION LIST**

| KAEHWADONG LOAD |
| SEOUL-SUWON INDUSTRIAL |
| SEOUL-INCHEON LOAD |
| KOSANJA LOAD |
| AIRPORT LOAD |
| KWANAK LOAD |
| KWANGNARU LOAD |
| SOUTHERN PRINCIPAL LOAD |
| RODEUL LOAD |
| NORYANGJIN LOAD |
| NONHYUN LOAD |
| DAEBANG LOAD |
| DAEHAK LOAD |
| DOGOKDONG LOAD |
| DOLIMCHEON LOAD |
| DOBONG LOAD |
| DOSAN LOAD |
| DOKSEODANG LOAD |
| EASTERN PRINCIPAL LOAD |
| DONGSOMUN LOAD |
| DONGJAK LOAD |
| DONGHO LOAD |

⋮

**FILE OPEN**

**RECOGNITION SERVER**

IP : 127 . 0 . 0 . 1  DISCONNECT

**VOICE RECOGNITION**

Start    Stop

☐ Continuous

**VOICE RECOGNITION RESULT**

Recognized Word :JINHEUNG LOAD[0.74]

20

**Mic Gain**

74

Play   NOISE REMOVE

Copyright(C) 2003 HCILab    RUN OUT

10

EP 1 669 978 A1

# FIG. 3

110

SPEECH

MICROPHONE
220

SPEECH RECEIVER
200

RECEIVE LEVEL
CONTROLLER
240

SPEECH
DETECTOR
310

350
SPEECH SATURATION
DETECTOR

370
INPUT LEVEL
DETERMINER

SPEECH CORRECTOR

SPEECH RECOGNIZER
330

300

# FIG. 4A

ENERGY

UPPER LIMIT THRESHOLD VALUE

LOWER LIMIT THRESHOLD VALUE

SAMPLE

# FIG. 4B

ZERO CROSSING RATE

THRESHOLD VALUE

SAMPLE

EP 1 669 978 A1

# FIG. 5

START

RECEIVE AND OUTPUT USER'S SPEECH AT SET INPUT LEVEL — S110

DETECT SPEECH PERIOD — S130

S150

IS SPEECH PERIOD DETECTION SUCCESSFUL? — NO

YES

DETERMINE WHETHER SPEECH IS SATURATED — S170

S190

IS SPEECH SATURATED?

NO ← YES →

S230

PERFORM SPEECH RECOGNITION PROCESSING

DETERMINE INPUT LEVEL — S210

**European Patent Office**

**EUROPEAN SEARCH REPORT**

Application Number

EP 05 02 6106

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 841 385 A (XIE ET AL) 24 November 1998 (1998-11-24) | 1-3,5,6, 8-11,13, 14,16-18 | G10L11/02 H03M1/18 H03G3/20 G10L15/02 |
| Y | * page 1, column 2, line 40 - line 53 * | 4,7,12, 15 | |
| | * page 2, column 3, line 20 - line 56 * * page 1, column 1, lines 31-34 * * page 3, column 6, lines 19-24 * * claim 2 * ----- | | |
| Y | US 2004/133421 A1 (BURNETT GREGORY C ET AL) 8 July 2004 (2004-07-08) * page 2, paragraph 20 * * page 2, paragraph 21 * * page 5, paragraph 63 * ----- | 4,12 | |
| Y | US 6 651 040 B1 (BAKIS RAIMO ET AL) 18 November 2003 (2003-11-18) * page 6, column 11, lines 7-16 * ----- | 7,15 | |

TECHNICAL FIELDS SEARCHED (IPC)

G10L
H03M
H03G

The present search report has been drawn up for all claims

| Place of search | Date of completion of the search | Examiner |
|---|---|---|
| Munich | 28 March 2006 | Aalburg, S |

EPO FORM 1503 03.82 (P04C01)

**ANNEX TO THE EUROPEAN SEARCH REPORT
ON EUROPEAN PATENT APPLICATION NO.** EP 05 02 6106

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2006

| Patent document cited in search report | | Publication date | Patent family member(s) | | Publication date |
|---|---|---|---|---|---|
| US 5841385 | A | 24-11-1998 | NONE | | |
| US 2004133421 | A1 | 08-07-2004 | AU | 7695501 A | 30-01-2002 |
| | | | CA | 2416926 A1 | 24-01-2002 |
| | | | CN | 1443349 A | 17-09-2003 |
| | | | EP | 1301923 A2 | 16-04-2003 |
| | | | JP | 2004509362 T | 25-03-2004 |
| | | | WO | 0207151 A2 | 24-01-2002 |
| | | | US | 2002039425 A1 | 04-04-2002 |
| US 6651040 | B1 | 18-11-2003 | NONE | | |

EPO FORM P0459

For more details about this annex : see Official Journal of the European Patent Office, No. 12/82